# EUROPEAN PATENT APPLICATION

(11) **EP 0 599 720 A2**
(43) Date of publication of application: **01.06.1994**
(21) Application number: 93402831.7
(22) Date of filing: 22.11.1993
(51) Int. Cl.: G03F 1/00, G03F 7/16, G03G 7/00

(54) **Photosensitive article and process for transferring an image thereto**

(30) Priority: 23.11.1992 US 980203
(71) Applicant: MINNESOTA MINING AND MANUFACTURING COMPANY, St. Paul, Minnesota 55133-3427 (US)
(72) Inventor: Zwadlo, Gregory L., c/o Minnesota Min. & Man. Co., St. Paul, Minnesota 55133-3427 (US); Chang, Jeffrey C., c/o Minnesota Min. & Man. Co., St. Paul, Minnesota 55133-3427 (US); Jasperson, Keith E., c/o Minnesota Min. & Man. Co., St. Paul, Minnesota 55133-3427 (US)
(74) Representative: Warcoin, Jacques

(57) **Abstract**

A photosensitive article containing: (a) a lower photoresist layer sensitive to radiation in the wavelength range of about 300 to 1000 nm; and (b) a thermoplastic upper layer which is capable of being removed from the photoresist lower layer without affecting the photosensitivity of the lower photoresist layer.

A process for transferring and developing an image involving the steps of: (a) producing a toned image on the surface of an electrophotographic element; (b) transferring the toned image to the thermoplastic layer of the inventive photosensitive article; (c) exposing the resulting photosensitive article with electromagnetic radiation having a wavelength in the range of 300 to 1000 nm; (d) removing the thermoplastic upper layer of the photosensitive article; and (e) developing the resulting image on the lower photoresist layer of the photosensitive article.

## Description

### Field of the Invention

This invention relates to a photosensitive article useful as a lithographic printing plate. This invention also relates to a process for transferring an image to a photosensitive article.

### Background of the Art

Printing of general commercial literature such as books, catalogues, greeting cards, and business forms utilizes a process known as lithography or planography. In this process, the imaged and nonimaged areas are approximately on the same plane, and the difference between imaged and nonimaged areas is maintained by the physicochemical principle that grease and water do not mix. The imaged area is grease-receptive and water-repellent; the nonimaged area is water-receptive and grease-repellent. Therefore, the organic-based ink adheres only to the imaged areas, from which it is transferred to the surface to be printed. The imaged area in a negative-acting system is provided by polymerization of a photoresist which has been struck by light. The unimaged resist is removed when the article is developed, leaving only the grease-receptive and water-repellent imaged areas of the resist.

Bilayer printing plate assemblies comprising an upper photoconductive layer and a lower photoresist layer are known in the art. Such systems are described in a paper by Kitamura and Kokado, *Photographic Science and Engineering,* **26**, 158 (1982). A first imaging exposure by visible or near UV light gives an electrostatic image on an organic photoconductive layer (metal-free phthalocyanine in a binder) which is then toner developed. A second flash exposure with deeper UV radiation, to which the presensitized plate layer is sensitive, reproduces the toner image in the photoresist layer. Finally, application of aqueous alkali is needed to remove both the photoconductive layer with its toner and the unexposed regions of the photoresist, thereby providing a lithographic printing plate.

U.S. Pat. No. 2,939,787 discloses a variation of the above-described system in which the top layer is ZnO in a non-aqueous binder and the underlayer is a photoresist layer. The procedure is the same except that toluene is used to remove the photoconductive layer and then warm water is used to remove unhardened areas of photoresist. This is followed by etching of the metal substrate plate. In U.S. Pat. No. 4,226,930 the toner mask is produced on an electrographic material separately and then transferred to the presensitized plate surface for flash exposure and development with the required plate developers.

U.S. Pat. No. 4,521,503 discloses a photoimageable printing assembly comprising an electroconductive support and a dual layer photosensitive construction. The dual layer photosensitive construction comprises (1) a photoresist lower layer sensitive to radiation in the wavelength range of 250 to 450 nm, the photoresist being soluble or dispersible in an aqueous solvent only, in either the exposed or unexposed regions; and (2) a photoconductive upper layer comprising zinc oxide in a water-soluble or water-dispersible binder, the layer being dispersible in an aqueous solvent. The disclosed assembly can be useful for making printing plates and printed circuits.

U.S. Pat. No. 4,600,669 describes an electrophotographic proofing element and process in which successive liquid toned color images are formed on a temporary photoconductive support. The composite image is then transferred to a receptor layer. The photoconductive layer has a releasable dielectric support coated thereon which may comprise a polymeric overcoat on the photoconductive layer which is transferred with the composite image.

U.S. Pat. No. 4,515,882 describes an electrophotographic imaging system using a member comprising at least one photoconductive layer and an overcoating layer comprising a film-forming continuous phase of charge transport molecules and charge injections enabling particles.

U.S. Pat. No. 4,565,760 describes a photoresponsive imaging member comprising a photoconductor layer and, as a release protective coating over at least one surface, a dispersion of colloidal silica and a hydroxylated silsesquioxane in alcohol medium.

U.S. Pat. No. 4,600,673 describes the use of silicone release coatings on photoconductive surfaces to increase the efficiency of toner transfer in electrophotographic imaging processes.

U.S. Pat. No. 4,721,663 describes an improved enhancement layer used in electrophotographic devices between a top protective layer and the photoconductor layer.

U.S. Pat. No. 4,752,549 describes an electrophotographic receptor having a protective layer consisting of a thermosetting silicone resin and a polyvinyl acetate resin. The combination provides improved densability.

U.S. Pat. Nos. 4,401,743 and 4,408,532 disclose lithographic printing plate constructions without an upper photoconductive layer. Those patents disclose a light-sensitive adduct comprising the combination of a diazo resist having a plurality of pendant diazonium groups and a sulfonated polymer having a plurality of sulfonate groups and a presensitized light-sensitive article comprising a substrate having a light-sensitive coating which is comprised of the light-sensitive adduct on a surface thereof. After imagewise exposure, unexposed portions of the coating are removable by water or aqueous developers.

Photosensitive films for use in electrophotography are also known in the art. For example, British Appln. No. 2,184,556 discloses a photosensitive film in which a photosensitive layer comprising a coloring agent and a photopolymer is provided on one face of plastic film with a heat-resistant temperature of higher than 100°C, and a transparent and strippable peel layer is provided on the photosensitive layer or on the opposite face thereof. The photopolymer to be contained in the photosensitive layer is a material which has properties that change by processes such as polymerization, crosslinking, dimerization, decomposition, rearrangement, and its solubility to solvents is increased or decreased through the irradiation of light, and is also conventionally an organic or inorganic photosensitizing material for plate-making, photosensitive resin, photoresist, etc. Examples of such photosensitive materials include diazo resins and azide compounds. The strippable peel layer is disclosed as being selected from among film-forming high molecular weight substances such as polystyrene, polyvinyl acetate, polyacrylates, methyl methacrylate-acrylate copolymers, methyl methacrylate-vinyl acetate copolymers, vinyl chloride-vinyl acetate copolymers, polyvinylidene chloride, vinylidene chloride-vinyl acetate copolymers, polyvinyl butyral, natural rubber, cyclized rubber, synthetic isoprene rubber, polyvinyl formal, and polyesters.

Numerous processes have been proposed in the art for transferring an image, typically from an electrostatic surface, to a print medium. The typical image transfer procedure is rather complicated and involves the steps of: uniformly charging a photoconductive layer; imagewise exposing it to a light source to which a photoresist layer is not light-sensitive in order to prepare an electrostatic latent image on the photoconductive layer; developing the latent image with a toner; fixing or non-fixing a toner image; exposing the photoresist layer to different conditions than those disclosed above in order to harden the exposed portion of the photoresist layer; removing the toner image and the photoconductive layer; removing the unhardened portion of the photoresist layer with a solvent; etching a metal layer; and removing the photoresist layer remaining on a metal layer. Thus, it is quite clear that a high degree of skill is required in order to prepare a good printing plate. However, the resolving power of the plate is not satisfactory since the development of an electrostatic latent image formed on the photoconductive layer is carried out by a dry method which is inherently lower resolution than a liquid method. Furthermore, clearness of a printing image thus obtained is not satisfactory because of the removal of a photoresist layer and an etching operation of a metal layer.

U.S. Pat. No. 4,337,303 discloses a method of transferring, encapsulating, and fixing dried liquid toner images in electrography. Stable, abrasion-resistant articles exhibiting continuous tone and transmission optical densities within the range of 0 to 4.0 are disclosed.

U.S. Pat. No. 4,728,983 discloses a method of making high quality color prints by electrophotography. The prints are particularly suited to color proofing. A single electroconductive drum is used together with means to electrostatically charge, laser-scan expose, and toner develop during one rotation of the drum. In successive rotations different colored images corresponding to color separation images are assembled in register on the drum. This assembled color image is transferred to a receptor sheet in a final rotation of the drum.

U.S. Pat. No. 5,023,668 discloses an automated lamination system for transferring an image to a print medium which includes a photoconductive drum bearing a toned image on an electrostatic outer surface thereof.

U.S. Pat. No. 5,108,865 discloses an electrographic imaging process by generating an electrostatic image, contacting the image with a temporary receptor sheet comprising a carrier layer, releasable release layer, and transferable adhesive layer secured to the release layer. The image is adhered to the adhesive surface, and that surface with the image thereon is then contacted with a final receiving (receptor) surface. The adhesive layer secures the toner image, adhesive layer, and the release layer (now a top protective layer) to the final receiving surface to generate the final image.

U.S. Pat. 4,894,679 discloses a method for exposing a photosensitive material to UV radiation. First, a film strip is indexed along a path which extends through a linear array of stations. At a charging station an electrostatic charge is applied to the photoconductive layer on the film strip. At an exposing station, the photoconductive layer on the film strip is exposed to a light pattern which forms a reduced size image of an original to thereby render areas of the photoconductive layer conducting. At a developing station, toner particles are electrically attracted to the conducting areas of the photoconductive layer on the film strip. The toner particles are fused to each other and the material of the film strip to form a permanent visible image. The film strip is then indexed to an exposing station where UV radiation is directed through the film strip to project an enlarged image onto photosensitive material. The UV radiation has an energy level of at least 500 ergs per square centimeter at the surface of the photosensitive material to initiate a photochemical reaction in the photosensitive material so that the image of the original on the film strip is transferred to the photosensitive material.

From the foregoing, it can be seen that in conventional electrophotographic imaging processes, a photoconductor is exposed and toner is fused on the photoconductor as a permanent image (or mask). The mask is then placed in front of a photosensitive plate and image transfer takes place by light exposure through the mask to the photosensitive plate.

One disadvantage of the conventional process, though, is that because the photosensitive printing plate is exposed through the photoconductor, the photoconductor can only be used once and is destroyed in the process. Additionally, the contact between the mask and the photosensitive plate is sometimes not sufficiently intimate or close enough to provide precise (transfer) imaging or requires a time-consuming vacuum frame to assure precise images.

In view of the foregoing, a photosensitive printing plate construction or article which is highly receptive to the transfer of toner from a photoconductor to a removable receptor layer on top of the photosensitive printing plate would be desirable in the industry. Such a photosensitive printing plate or article would allow for utilization of a process whereby toner could be transferred from a photoconductor to a removable receptor layer on top of the photosensitive printing plate or article, thereby allowing for reuse of the photoconductor as well as enhancing the preciseness of the imaging process. Since the receptor layer would be removable, the mask would be available for storage of the image for future plate production.

### Summary of the Invention

The present invention provides novel photosensitive articles which are particularly useful for making high resolution lithographic printing plates directly from electrophotographic processes which use, for example, a high resolution (3,200 dots/inch) laser-scan addressed liquid toner imaging system to make high resolution color half-tone separation images. The photosensitive articles of this invention as disclosed later herein comprise a suitable substrate; a light-sensitive, positive- or negative-acting photopolymer underlayer; a removable, thermoplastic, toner-receptive upper layer; and optionally, a barrier interlayer.

Black toner images, or toner which absorbs light to which the photosensitive article is sensitive, generated from electrophotographic process are thermally transferred to the removable, thermoplastic layer of the photosensitive article or plate and are subsequently used as an in situ photomask to expose the underlying photoresist. By integrating the photomask or negative film into a single plate construction, the plate, after receiving toner images, can be exposed to cure the underlying photopolymer without needing a vacuum frame and a yellow safelight. The photomask is then removed (e.g., peeled or washed off) and the plate is processed by conventional development methods known to those skilled in the art.

Thus, in one embodiment the present invention provides a photosensitive article which comprises: (a) a lower photoresist layer sensitive to radiation in the wavelength range of about 300 to 1000 nm, preferably in the wavelength range of about 300 to 500 nm; and (b) a thermoplastic upper layer which is capable of being removed from the photoresist lower layer and which does not affect the photosensitivity of the lower photoresist layer.

In one preferred embodiment, the photoresist lower layer is a conventional negative-acting one and comprises free-radically polymerizable, ethylenically unsaturated monomer (e.g., acrylates, methacrylates, acrylamides, etc.). Additionally, the photoresist is preferably thermally stable and soluble in aqueous-based development solution in either the exposed or unexposed areas (depending upon whether the article is positively or negatively developable).

In another preferred embodiment, the thermoplastic upper layer has a glass transition (T_{g}) temperature in the range of about 5° to 100°C, more preferably in the range of about 20° to 60°C, and is capable of receiving toner image below about 110°C, preferably in the range of about 30°-100°C, under moderate to low pressure (e.g., about 0.3 to 5.0 kg/cm²), to avoid damaging photoconductor and/or image resolution. Examples of thermoplastic resins which can be used in the present invention include, but are not limited to, copolymers of vinyl chloride and vinyl acetate, polyacrylates, and epoxy resins. The resins can be used alone or blended together to achieve a desired thermal adhesive property and are coated from organic solvents or water.

In still another preferred embodiment, a barrier interlayer is provided in order to prevent solvent from damaging the photoresist underlayer when an aggressive solvent is used to coat the removable, toner-receiving, thermoplastic upper layer. The barrier interlayer may also be removed with the thermoplastic upper layer under appropriate conditions. Preferred interlayer polymers are water soluble such as poly(vinyl alcohol), poly(vinyl pyrrolidone), etc. Gantrez™ poly(methyl vinyl ether/maleic anhydride) copolymer (available from GAF Corp.) may also be used.

In another embodiment, the present invention provides a process for the transfer and development of an image comprising the steps of: (a) producing a toned image on the surface of an electrophotographic element; (b) transferring the toned image to the thermoplastic upper layer of the above-described inventive photosensitive article; (c) exposing the resulting photosensitive article from (b) with electromagnetic radiation having a wavelength in the range of about 300 to 1000 nm; (d) removing the thermoplastic upper layer; and (e) developing the resulting image on the lower photoresist layer of the photosensitive article.

In a preferred embodiment, the toner used is liquid toner having a transmission optical density (T.O.D.) in the range of about 1 to 4.5 and more preferably in the range of about 2 to 3.5. The toner image is generally transferred to the thermoplastic upper layer at a transfer temperature in the range of about 20° to 110°C, and preferably at about 30° to 100°C under moderate to low pressure, e.g. about 0.3 to 5.0 kg/cm².

The inventive photosensitive article is particularly advantageous because it contains a thermoplastic upper layer which is highly receptive to receiving a toned image. Additionally, the thermoplastic layer can be removed (e.g., by peeling or washed away) from the photosensitive article and is therefore reusable.

The inventive image transfer process is quite beneficial since the toned image is transferred to the thermoplastic layer of the photosensitive article and therefore, the electrophotographic surface (photoconductor) from which the toned image is transferred is not destroyed as in conventional toned image transfer processes and as discussed earlier herein, can be utilized again.

Other aspects, advantages, and benefits of the present invention are apparent from the detailed description, the examples, and the claims.

### Detailed Description of the Invention

The lower photoresist layer used in the inventive photosensitive article comprises a substrate (opaque or transparent) and a light-sensitive (in the range of about 300 to 1000 nm, preferably in the range of about 300 to 500 nm) negative- or positive-acting photopolymer underlayer.

Substrates that are useful in practice of the present invention include sheet materials such as paper, plastic, or metal and preferred are those that are permanently hydrophilic and conventionally used in the preparation of lithographic printing plates. Aluminum, which has first been cleaned and treated to render it permanently hydrophilic, is the most preferred substrate of lithographic constructions. Well-known methods for treating the aluminum plate include silicating, electrolytic anodizing, mechanical graining, or combinations thereof. In addition to providing a durable hydrophilic background, the treatment can also influence coating performance characteristics such as exposure time, ease of development, image adhesion, press life, etc.

The photopolymer layer of the lower photoresist layer of the present invention may comprise any resist imageable or self-developing photopolymeric imaging layer known in the art which is sensitive to light in the range of about 300-1000 nm, preferably in the range of about 300-500 nm. By "resist imageable" is meant a layer whose solubility in a particular solvent is sufficiently altered by irradiation such that an image of the irradiated pattern of photopolymer will remain on the plate after exposure and development (negative-acting system) or a pattern of irradiated polymer will be removed after exposure and development (positive-acting system). Typical lithographic plating materials include various combinations of photopolymerizable polymers, oligomers, and monomers; inert polymeric binders; photoinitiators; spectral dye sensitizers; colorants; surfactants; solvents; and the like. The photopolymer system used in the present invention, however, should be one that has good thermal stability at the toner transfer temperature.

Negative-acting photoresists are known in the art and include, but are not limited to, free-radically polymerizable monomers such as acrylic esters, methacrylic esters, and acrylamides. Conventional positive-acting photoresists can also be used, e.g, diazo-oxide/phenol formaldehyde systems.

In one preferred embodiment, light-sensitive photopolymer layers of the present invention comprise radiation-sensitive adducts of a diazonium resin having a plurality of pendant diazonium groups and certain sulfopolyesters having a plurality of sulfo groups such as those disclosed in U.S. Pat. No. 4,408,532, incorporated herein by reference; modifying additives such as thermoplastic polymers to improve coating properties in abrasion resistance, ink receptivity, etc.; photopolymerizable compounds and photoinitiators to enhance the solubility difference between exposed and non-exposed areas; organic solvent-soluble diazonium salts such as 4-toluene-diazonium-p-toluenesulfonate for better print acuity; and colorants to facilitate visual inspection.

Exemplary radiation-sensitive polymeric adducts suitable for use in this invention include the reaction product of a diazonium resin, zinc chloride double salt of the formaldehyde condensation product of p-diazodiphenylamine prepared according to U.S. Pat. No. 2,714,066 and EPA 462,704, and an amphorous sulfopolyester. The term "sulfo", as used herein, designates the group -SO₃M in which M is an alkali metal cation such as sodium, potassium, and lithium. The sulfopolyesters, prepared according to EPA 462,704, the disclosure of which is incorporated by reference herein, are the product of the esterification of ethylene glycol, neopentyl glycol, and at least two dicarboxlic acids. An exemplary polyester contains 10 mole % sulfoisophthalate, 45 mole % isophthalate, 15 mole % sebacate, 30 mole % 5-t-butyl isophthalate, 36 mole % ethylene esters, 61 mole % neopentyl esters, and 3 mole % diethylene glycol esters. It has a sulfo equivalent weight of about 2500, a T_{g} of 47°C and a molecular weight of about 40,000. The sulfopolyester is completely soluble in methyl ethyl ketone as well as in water/isopropanol (90/10).

Exemplary thermoplastic additives are sulfopolyesters, sulfonated polyurethanes, and UCAR® VYNS-3 vinyl chloride/vinyl acetate copolymer (available from Union Carbide Corp.). They can be used up to 30 percent by weight of the total solids content of the photoresist layer. Exemplary photoinitiators are chromophore-substituted-vinyl-halomethyl-s-triazines. Exemplary colorants are pigment dispersions such as the "Microlith" series (tradename for pigment predispersed in a vinyl resin from Ciba Geigy Corp.).

Coating of the photopolymer layer may be achieved by any method known in the art (e.g., solvent casting, knife coating, slot coating, etc.). Preferably, the light sensitive photopolymer solution is coated onto a substrate that has been primed by a thin (e.g., 0.5 to 15 mg/m²) layer of a subbing compound such as hydrolyzed polyvinyl alcohol or an aqueous solvent-soluble polymeric diazonium compound. The coating weight of the photopolymer layer is preferably between about 0.4 to 2.0 g/m².

Exemplary developers suitable for developing the exposed photoresist include aqueous solutions of water soluble organic solvents such as 2 to 5 weight percent of benzyl alcohol in water. Anionic surfactants such as sodium lauryl sulfonate and desensitizing salts such as sodium sulfite can be added to the developer solution.

Preferably, a barrier interlayer is provided between the photoresist underlayer and the removable thermoplastic upper layer to prevent any unwanted physical and chemical interaction between these two layers during coating or processing such as transferring toner under heat and pressure. Useful polymers should preferably have a solubility of at least about 0.5 wt% in water or water/alcohol mixtures, and the resulting coatings should be transparent to the selected radiation light spectrum and be optically clear (i.e., non-scattering). Preferably, the coatings are good barriers to gases such as oxygen and nitrogen and are easily removable from the photopolymer underlayer. Under appropriate conditions, the barrier interlayer may be removed from the lower photoresist lower layer along with the thermoplastic upper layer.

Polymers that can be used as the barrier interlayer are hydrophilic organic polymers including, but not limited to, cellulosic polymers such as hydroxypropyl cellulose and methyl cellulose, and vinyl polymers such as poly(vinyl alcohol), poly(vinyl pyrrolidone), and poly(methyl vinyl ether/maleic anhydride) copolymer. Preferably, the polymers have a T_{g} above about 40°C. The dry coating weight of this layer is preferably between about 0.1 to 2.5 g/m².

Thermoplastic materials that can be used as the toner image receptor in the present invention include those that exhibit low melt viscosity which permits the thermoplastic resin to flow readily around and into the microstructure associated with the toner particles. The preferred materials are low molecular weight and low T_{g} polymers which are solid and non-tacky at room temperature, but become a viscous fluid at elevated temperatures. Examples of suitable polymers are the low molecular weight epoxy resins made by the condensation of epichlorohydrin and Bisphenol A such as those available from Shell Chemical Co. under the tradename of Epon; Bisphenol A-fumarate polyesters available from Reichold Chemical Co. under the tradename of Atlac; and polyacrylates available from Rohm and Haas under the tradename of Acryloid.

Other low T_{g} polymers including, but not limited to, vinyl resins such as copolymer of vinyl chloride/vinyl acetate (e.g., VYLF, T_{g} = 68°C, available from Union Carbide Corp.); copolymer of vinyl chloride/vinyl acetate/vinyl alcohol (e.g., VYES, T_{g} = 53°C, available from Union Carbide); ethylene vinyl acetates; and copolyester resins (e.g., Vitel VAR-4302A, T_{g} = 32°C, available from Goodyear) are also useful. These materials can be used alone or blended together to obtain a desired thermal adhesive property. Compatible plasticizers known in the art (e.g., adipic acid polyester, polyvinyl stearate, etc.) that would decrease polymer melt viscosity and enhance tensile strength can also be added to the coating formulation. To improve coating quality and ease of separating the coating from the photoresist underlayer, low surface energy surfactants such as Fluorad FC-431 (fluorochemical surfactant from 3M Company) can also be used up to 15 wt% of the total solids content. The removable, thermoplastic toner-receiving layer may be coated either from water or organic solvent-based solutions. A coating weight range of about 1.0 to 20 g/m² is preferred.

The thermoplastic upper layer has a preferred T_{g} in the range of about 5° to 100°C, more preferably in the range of 20° to 60°C, and is capable of receiving the toner image below about 110°C, preferably in the range of 30° to 100°C, under 0.3 to 5 kg/cm² pressure.

The thermoplastic upper layer of the inventive photosensitive article should be able to perform the following functions: (1) be highly receptive and capable of adhering to the toner particles of the image transferred from a photoconductor without losing image resolution under heat and pressure; (2) be useful as a photomask for the underlying photoresist and be transparent to the desired UV radiation; and (3) be separable or removable without inflicting any damage to the photoresist underlayer.

The inventive process for transferring and developing an image comprises the steps of: (a) producing a toned image on the surface of an electrophotographic element; (b) transferring the toned image to the thermoplastic upper layer of the above-described inventive photosensitive article; (c) exposing the resulting photosensitive article from (b) with electromagnetic radiation having a wavelength in the range of about 300 to 1000 nm, preferably in the range of about 300-500 nm; (d) removing the thermoplastic upper layer; and (e) developing the resulting image on the lower photoresist layer of the photosensitive article.

A toned image may be produced on surface of an electrophotographic element according to well known, conventional processes. Generally, a photoconductive member is usually imaged by uniformly electrostatically charging the imaging surface in the dark and exposing the member to a pattern of activating electromagnetic radiation, such as light, to selectively dissipate the charge in the illuminated areas of the photoconductive member to form an electrostatic latent image on the imaging surface.

In order to gain an efficient and complete transfer of a toned image to the thermoplastic layer, the electrophotographic process must be fully compatible with the thermoplastic upper layer utilized in the inventive photosensitive article. The thermoplastic layer must be able to receive and secure toner images from photoconductor surfaces under useful transfer conditions, e.g., at a temperature between about 20° and 100°C at 0.3 - 5 kg/cm² pressure, depending on the type of photoconductor and toner used. A convenient way of supplying heat and pressure for the toner image transfer is by means of a hot press roller. The hot roller presses the photosensitive article against the photoconductor drum to make an intimate contact between the toner-receiving, thermoplastic upper layer and the toner images on the photoconductor drum during the toner image transfer process. Heat is transferred from the roller to soften the thermoplastic toner-receiving binder and the toner particles and to induce proper bonding between them.

In a preferred embodiment, the photoconductor drum consists of a metal drum wrapped around with an aluminized polyester film which is coated with a layer of organic photoconductor (OPC) comprising BBCPM (bis-5,5'-(N-ethylbenzo(a)carbazolyl)-phenylmethane) in a Vitel PE-207 polyester binder (Goodyear), sensitized with an indolenine dye having a peak absorption in solution at a wavelength of 787 nm. The OPC comprises a thin polydimethylsiloxane release topcoat (5 to 300 nm thick) as disclosed in U.S. Pat. No. 4,600,673. This low surface energy release topcoat helps transfer toner images from its surface to the thermoplastic toner receptor while retaining image resolution.

In an another preferred embodiment, liquid toned images are used because of their high image resolution. Liquid toners can have very small particle sizes (less than 1 micrometer) and normally contain up to 75% by weight of pigments in a thermoplastic binder with a low T_{g}. Preferably, the liquid toner has a T.O.D. in the range of about 1 to 4.5, more preferably in the range of about 2 to 3.5. The toner images deposited on the photoconductor surface also contain a substantial amount of liquid carrier which tends to smear image resolution during the toner transfer step. For this reason, drying of the deposited liquid toner image prior to the transfer step is preferred.

The temperature of toner transfer according to the process of the present invention is preferred to be in the range of about 30°-100°C because higher temperatures may cause damage to the photoconductors.

After exposure to radiation of a suitable wavelength (i.e., about 300 to 1000 nm), the thermoplastic upper layer of the photosensitive article may be removed from the lower photoresist layer, typically by simply peeling or washing. For example, a transparent base or carrier film (e.g., PET film) is laminated, under heat and pressure, to the thermoplastic upper layer and then the resulting laminate is peeled off from the photoresist layer as a composite film. The resulting exposed lower photoresist layer is then developed by conventional methods, e.g., utilizing aqueous alkali solution.

The following non-limiting examples further illustrate the present invention.

### EXAMPLE 1

Preparation and evaluation of toner-receptive printing plate

A 9'' x 20'' silicated, aluminum, diazo-type plate (VIKING GX, available from 3M Co.) was coated using a #16 Meyer bar with 5 % by weight of a printing plate solution containing 60.4 parts by weight (pbw) ketone soluble polyester diazo adduct, 17.0 pbw sulfonated polyester, 6.0 pbw cellulose acetate butyrate, 0.6 pbw 4-phenylazo diphenylamine, and 16.0 pbw millbase composed of VYNS-3 (vinyl chloride/vinyl acetate copolymer available from Union Carbide Corp., Danbury, CT) and phthalocyanine blue, 1896 pbw methyl ethyl ketone (MEK), and 4.0 pbw water. After drying, the plate was overcoated with 5 wt % poly(vinyl alcohol) (PVA) in water using a #12 Meyer bar.

A resin blend of VYLF™ poly(vinyl chloride/vinyl acetate) copolymer (from Union Carbide Corp.) and Acryloid™ A-82 polyacrylate (available from Rohm and Haas Co., Philadelphia, PA.), in a one-to-one weight ratio, thermally receptive to a liquid toner image, was prepared. The blend was dissolved in MEK to make up a 10% by weight solution. The solution also contained about 0.15 wt% of FC-431 fluorochemical surfactant (3M Co., St. Paul, MN). This solution was knife-coated on top of the PVA-coated plate at 3 mil wet thickness.

The dried plate was then tested for toner receptivity through a digital color proofing prototype. A digitized image consisting of 10 half-tone gray scales was first used to expose an infrared-sensitive BBCPM photoconductor on a drum. A black liquid toner using Regal® 300 carbon black or 3M Digital Matchprint™ black ink (3M 099K087, 3M, St. Paul, MN) (prepared according to Examples 2 and 4 of U.S. Pat. No. 5,061,583) was used to develop the latent image under electrostatic field conditions to give a high density image. The plate with coated surface facing the toner image was fed through a nip between a hot rubber roller and the photoconductor drum. Under pressure and heat, the thermoplastic coating became tacky and completely picked up the toner image from the silicone treated organic photoconductor surface. The image looked sharp and clean through a direct measuring microscope.

The plate was then exposed to UV light in a Berkey Ascor unit for 80 seconds and the topcoat was peeled off. The plate was developed with a Viking™ plate developer solution (3M Co., St. Paul, MN) and all the unexposed areas were washed off. This resulted in a clean, sharp image with 10 half-tone steps on the plate.

### EXAMPLE 2

Preparation and evaluation of a printing plate top-coated with a water soluble resin

Two printing plates, machine coated with the same printing plate solution as in Example 1, were coated, respectively, with 5 wt% poly(vinyl alcohol) and a 6.7 wt% poly(N-vinyl pyrrolidone) solution in water with a #12 Meyer bar.

These plates were imaged, UV-exposed, and developed following the same procedure as used in Example 1. The resulting images on the plates were not as sharp as the previous ones because the toner transfer efficiency to these higher T_{g} materials was poorer.

### EXAMPLE 3

Printing plate only

The printing plate as made in Example 1, without any additional coating was evaluated. Under the same test condition as disclosed in Example 1, the printing plate was receptive to the toner images, but its receptivity towards the toner was not as good as the one used in Example 1.

Examples 2 and 3 show that contact transfer of toner to the printing plate is difficult without a coating with specified toner receptive properties. The black liquid toner used had a significant amount of film-forming ability.

### EXAMPLE 4

Positive acting plate

A 3M Viking™ PLX positive-acting printing plate was coated with 200 mg/ft² of poly(vinyl pyrrolidone/vinyl alcohol) copolymer (Luviskol™ VA-64 available from BASF Corp.). The plate was then coated with 15% by weight solution of Epon 1001 (epoxy resin, available from Shell Chemical Co., Houston, Texas) in MEK at 1 mil wet thickness and dried.

The plate was tested for toner transfer receptivity using the same method as described in Example 1. It was then exposed to UV light in a Berkey Ascor unit for 20 seconds and the topcoat was peeled off. The plate was developed with a Viking™ plate developer solution (3M Co., St. Paul, MN) and all the exposed areas were washed off. This resulted in a clean, sharp image on the printing plate.

### EXAMPLE 5

Preparation of scanner film from plate construction

The printing plate of Example 1 was coated with a #10 Meyer bar with a 5 wt % solution of poly(vinyl alcohol) in water and dried. The construction was then coated with a #15 Meyer bar of a 15 wt % solution of Carboset 525 acrylic (available from B.F. Goodrich) and EPON 1001 (epoxy resin, available from Shell Chemical Co., Houston, Texas) in Dowenol PM solvent (available from Dow Chemical Co.). The organic photoconductor was imaged as in Example 1, but with a commercial black liquid toner (VERSATEC SPC Black Premix from Versatec Company). After transfer, a 4 mil primed PET film was laminated to the surface and exposed to UV light as described in Example 1. The composite film of thermoplastic, toner, and poly(vinyl alcohol) was subsequently peeled off the plate with 100% efficiency from the photopolymer layer. The T.O.D. (transmission optical density) of the image measured over 2.0 and a microline resolution of 8 microns was observed. This demonstrated the ability of direct plate production combined with generation of film from the plate transfer process. The composite film was subsequently used as a mask for exposing another printing plate as in Example 1.

Reasonable modifications and variations are possible from the foregoing disclosure without departing from either the spirit or scope of the present invention as defined in the claims.

## Claims

1. A photosensitive article comprising: (a) a lower photoresist layer sensitive to radiation in the wavelength range of about 300 to 1000 nm; and (b) a thermoplastic upper layer which is capable of being removed from said photoresist lower layer and which does not affect the photosensitivity of said lower photoresist layer.

2. The photosensitive article according to Claim 1 wherein said lower photoresist layer is sensitive to radiation in the wavelength range of about 300-500 nm.

3. The photosensitive article according to Claim 1 wherein said lower photoresist layer is negative-acting.

4. The photosensitive article according to Claim 3 wherein said lower photoresist layer is positive-acting.

5. The photosensitive article according to Claim 1 wherein said thermoplastic upper layer has a T_{g} in the range of about 5° to 100°C.

6. A process for the transfer and development of an image comprising the steps of:
(a) producing a toned image on the surface of an electrophotographic element;
(b) transferring said toned image to the thermoplastic upper layer of the photosensitive article of Claim 1;
(c) exposing the resulting photosensitive article of (b) with electromagnetic radiation having a wavelength in the range of about 300 to 1000 nm;
(d) removing said thermoplastic upper layer of the photosensitive article; and
(e) developing the resulting image on the lower photoresist layer of the photosensitive article.

7. The process according to Claim 6 wherein step (b) said toned image is transferred to said thermoplastic upper layer at a temperature in the range of about 20° to 110°C under a pressure of about 0.3 to 5.0 kg/cm².

8. The process according to Claim 7 wherein said toned image is transferred to said thermoplastic upper layer at a temperature in the range of about 30° to 100°C.

9. The process according to Claim 6 wherein said radiation in step (c) has a wavelength in the range of about 300 to 500 nm.

10. The process according to Claim 6 wherein said toned image involves the use of liquid toner.
